Europäisches Patentamt

European Patent Office

Office européen des brevets

(19)

(11) Veröffentlichungsnummer : **0 412 573 B1**

# (12) EUROPÄISCHE PATENTSCHRIFT

(45) Veröffentlichungstag der Patentschrift :
28.06.95 Patentblatt 95/26

(51) Int. Cl.$^6$ : **H03K 7/06**

(21) Anmeldenummer : **90115460.9**

(22) Anmeldetag : **10.08.90**

(54) **Schaltungsanordnung für die Analogsignal-Frequenz-Wandlung.**

(30) Priorität : **11.08.89 DE 3926599**

(43) Veröffentlichungstag der Anmeldung :
**13.02.91 Patentblatt 91/07**

(45) Bekanntmachung des Hinweises auf die
Patenterteilung :
**28.06.95 Patentblatt 95/26**

(84) Benannte Vertragsstaaten :
**DE FR GB IT**

(56) Entgegenhaltungen :
**DE-A- 2 048 038**
**DE-A- 3 037 174**
**DE-A- 3 545 375**
**US-A- 4 435 697**

(56) Entgegenhaltungen :
**IEEE TRANSACTIONS ON INSTRUMENTA-
TION AND MEASUREMENTS, vol. IM-24, no.
3,September 1975, Seiten 255-261; P.E. ALLEN
et al.: "A wide range voltage-controlled oscillator"**
**DATA ACQUISITION PRODUCTS CATALOG
SUPPLEMENT, 1979 Analog Devices Inc., Seiten 92S, 254S**

(73) Patentinhaber : **Bodenseewerk Gerätetechnik
GmbH
Alte Nussdorfer Strasse 15
Postfach 1120
D-88662 Überlingen (DE)**

(72) Erfinder : **Marschall, Klaus
Dornerweg 1
W-7758 Meersburg (DE)**

(74) Vertreter : **Weisse, Jürgen, Dipl.-Phys. et al
Bökenbusch 41
Postfach 11 03 86
D-42531 Velbert (DE)**

EP 0 412 573 B1

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Technisches Gebiet

Die Erfindung betrifft eine Schaltungsanordnung zur Analogsignal-Frequenz-Wandlung mit einem Eingang für ein analoges Eingangssignal und Wandlermitteln zum Umsetzen analoger Signale in Frequenzen zur Verwendung mit einem Frequenz-Digital-Umsetzer und einem Prozessor nach dem Oberbegriff des Patentanspruchs 1.

Meßsignale werden von Sensoren in der Regel als analoge Signale geliefert. Zur Verarbeitung eines solchen Signals in einem Digitalrechner mit Prozessor muß das Signal in einen Digitalwert umgesetzt werden.

Häufig ist der Sensor auch entfernt von dem Rechner angeordnet. Das Signal muß daher zu dem Rechner übertragen werden. Bei analogen Signalen ist die genaue Signalübertragung sehr schwierig. Man setzt daher das Signal mittels eines Analogsignal-Frequenz-Wandlers in eine Frequenz um. Diese Frequenz kann zu dem Rechner relativ störungsfrei übertragen werden. Im Rechner wird aus der Frequenz, z.B. durch Abzählen der Impulse während einer vorgegebenen Zeit, ein Digitalwert gebildet. Diese Übertragung hat den Vorteil, daß die Frequenz nicht durch die Dämpfung eines Übertragungskabels oder ähnlicher Einflüsse gestört wird.

## Zugrundeliegender Stand der Technik

Es sind als integrierte Bauteile ausgebildete Spannungs-Frequenz-Wandler bekannt, die Eingangsspannungen in der Größenordnung von Volt verlangen. Die Wandlung geschieht mit einer Genauigkeit von ungefähr 0,8 % vom Endwert über dem Arbeitstemperaturbereich. Diese Genauigkeit wird nur erreicht, wenn jeder einzelne Wandler-Baustein jedes Rechners, bzw. Sensors nach Kennlinienversatz und Verstärkung von Hand abgeglichen wird. Die Genauigkeit der Wandlung wird stark von den Änderungen der Umgebungstemperatur beeinträchtigt durch Beeinflussung der kennzeichnenden Parameter der Bausteine.

Sensoren liefern aber häufig Signale im Bereich von Millivolt. Um solche Signale mit einem handelsüblichen Spannungs-Frequenz-Wandler verarbeiten zu können, muß eine Vorverstärkung der Signale erfolgen. Eine solche Vorverstärkung erfolgt durch einen Operationsverstärker. Dieser Operationsverstärker bringt aber durch Kennlinienversatz Abweichungen des Verstärkungsgrades und durch sein Temperaturverhalten ebenfalls Fehler in das zu wandelnde Signal hinein.

Durch die US-A-4 435 697 ist eine Schaltungsanordnung zur Analogsignal-Frequenz-Wandlung bekannt, bei welcher bekannte, analoge Abgleichsignale erzeugt werden. Das zu wandelnde, analoge Eingangssignal und die Abgleichsignale werden in vorgegebener Folge in je eine Frequenz umgesetzt. Ein Prozessor berechnet aus den beiden Digitalwerten, die aus den durch die Abgleichsignale erzeugten Frequenzen erhalten werden, und dem Digitalwert, der aus der durch das analoge Eingangssignal erzeugten Frequenz erhalten wird, einen dem analogen Eingangssignal entsprechenden, hinsichtlich Störeinflüssen korrigierten Digitalwert.

Bei der Schaltungsanordnung nach der US-A-4 435 697 sind die analogen Abgleichsignale und das zu wandelnde Eingangssignal Spannungen. Diese Spannungen werden direkt über Schalter auf einen Spannungs-Frequenz-Wandler aufgeschaltet, wobei die Schalter üblicherweise FETs sind. Das hat den Nachteil, daß ein Spannungsabfall an dem Schalter auftritt. Ein solcher Spannungsabfall kann sich beispielsweise mit der Temperatur ändern. Es hat sich gezeigt, daß dadurch bei der Wandlung von kleinen Sensor-Ausgangsspannungen unerwünschte Fehler hervorgerufen werden können. Eine ähnliche Anordnung, bei welcher Spannungen direkt über einen aus FET-Schaltern aufgebauten Multiplexer nacheinander auf einen Spannungs-Frequenz-Wandler aufgeschaltet werden, zeigt die US-A-4 380 757.

Es ist weiterhin bekannt, (z.B. Firmendruckschrift "Data Acquisition Products Catalog Supplement" (1979) der Analog Devices, Inc. S 925 and 254 S) durch Verwendung eingeprägter Ströme den Einfluss von Schalterwiderständen zu unterdrücken.

Offenbarung der Erfindung

Der Erfindung liegt die Aufgabe zugrunde, einen Analogsignal-Frequenz-Wandler als Einheit zu erzeugen, der in Verbindung mit einem Prozessor und als dessen "Interface"-Baustein empfindliche Sensorsignale direkt hochgenau in eine Frequenz wandeln kann und dessen Wandlungsgenauigkeit einer sehr geringen Beeinflussung durch Offset/Verstärkung und Temperaturgang unterliegt und der bei der Anwendung keinen individuellen Beschaltungsabgleich benötigt.

Erfindungsgemäss wird diese Aufgabe bei einer Schaltungsanordnung der eingangs genannten Art durch die Merkmale des Kennzeichens des Patentanspruchs 1 gelöst.

Nach der Erfindung werden also mit dem Analogsignal-Frequenz-Wandler bekannte Abgleichsignale er-

EP 0 412 573 B1

zeugt. Anhand dieser Abgleichsignale bestimmt der Prozessor eine Kennlinie Spannung über Frequenz mit zwei Eichpunkten. Diese Eichpunkte sind bestimmt durch die Digitalwerte, die den beiden analogen Abgleichsignalen zuzuordnen sind, mittels der zugehörigen, mit den Abgleichsignalen erzeugten Frequenzen. Für das Eingangssignale ergibt sich nach dieser Kennlinie ein bestimmter Digitalwert. Dieser Digitalwert ist unabhängig davon, ob sich etwa durch Temperaturveränderungen die Kennlinie des Analogsignal-Frequenz-Wandlers ändert und damit die dem Eingangssignal und den Referenzsignalen zugeordneten Frequenzen. Es wird zwar die Information durch eine Frequenz ausgedrückt, diese Frequenz allein liefert aber noch nicht den exakten Digitalwert für das zu messende Signal. Bei gleichem Eingangssignal kann die Frequenz für verschiedene Umgebungsbedingungen durchaus unterschiedlich sein.

Das analoge Eingangssignal kann eine Meßspannung sein. Die Schaltung enthält dann Mittel zur Umsetzung dieser Meßspannung in einen Meßstrom. Die Abgleichsignale sind eingeprägte Ströme. Diese Ströme sind auf einen Summierpunkt aufschaltbar. Der Summierpunkt ist mit einem stromgesteuerten Oszillator verbunden, der die Ausgangsfrequenzen liefert.

Es hat sich gezeigt, daß auf diese Weise analoge Eingangssignale im Bereich von Millivolt unmittelbar, d.h. ohne Vorverstärkung, zur Steuerung des Oszillators benutzt werden können.

Vorteilhafterweise erzeugt eine Referenzspannung über einen ersten Widerstand einen oberen und einen unteren Abgleichstrom. Als Referenzsignal wird über einen zweiten Widerstand ein Referenzstrom erzeugt. Gesteuert von dem Prozessor sind in einer ersten Wandlung der Meßstrom und der Referenzstrom auf den Summierpunkt aufgeschaltet. In einer zweiten Wandlung sind sowohl der obere Abgleichstrom als auch der Referenzstrom auf den Summierpunkt geschaltet. In einer dritten Wandlung ist der untere Abgleichstrom und der Referenzstrom auf den Summierpunkt aufgeschaltet.

Das ermöglicht die Signalverarbeitung im Prozessor zur Bestimmung des der Eingangsspannung zugeordneten Digitalwertes, der von der Umgebungstemperatur unabhängig ist.

Ein Ausführungsbeispiel der Erfindung mit einigen Abwandlungen ist nachstehend unter Bezugnahme auf die zugehörigen Zeichnungen näher erläutert.

## Kurze Beschreibung der Zeichnungen

Fig. 1    ist ein schematisches Schaltbild der Wandlerschaltung.

Fig. 2    zeigt schematisch die Überlagerung der Ströme zur Steuerung des stromgesteuerten Oszillators bei der Wandlerschaltung Fig. 1.

Fig. 3    zeigt die Beschaltung der als "Monolitisch integrierte Schaltung" ausgebildeten Wandlerschaltung, wenn die zu wandelnde analoge Eingangsgröße eine Spannung ist.

Fig. 4    zeigt die Beschaltung der Wandlerschaltung, wenn die zu wandelnde analoge Eingangsgröße ein elektrischer Widerstand ist.

Fig. 5    zeigt eine andere Art der Beschaltung, bei welcher die zu wandelnde analoge Eingangsgröße ein elektrischer Widerstand ist.

Fig. 6    zeigt die Anordnung der Wandlerschaltung in Verbindung mit einem Sensor, einem Frequenz-Digital-Umsetzer und einem Prozessor.

## Bevorzugte Ausführung der Erfindung

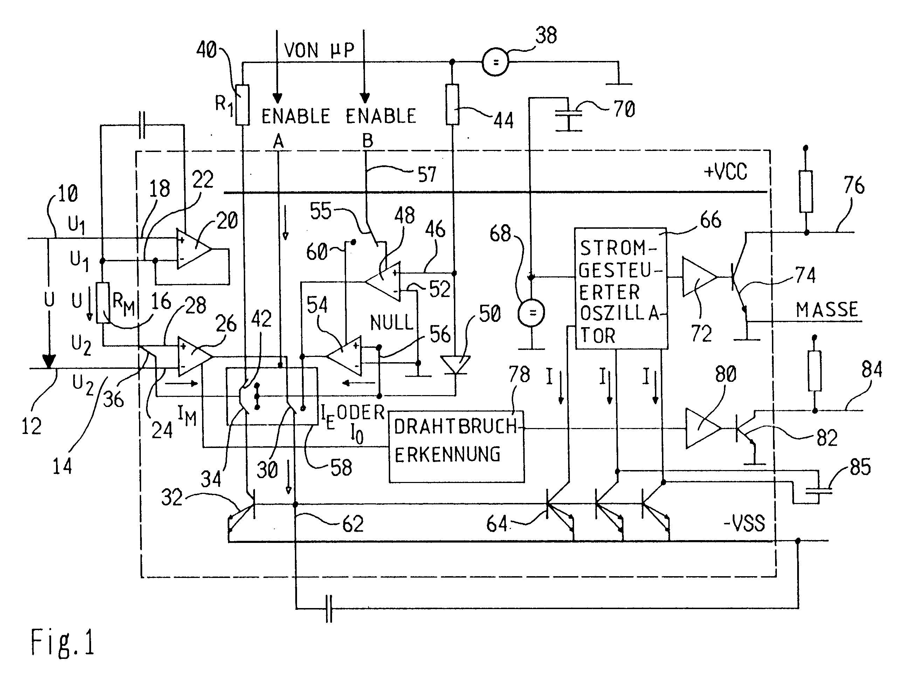

Als analoges Eingangssignal liegt bei der Ausführung nach Fig. 1 eine Meßspannung U an Eingangsklemmen 10 und 12 an. Der Wandler enthält Mittel 14 zur Umsetzung dieser Meßspannung U in einen dazu proportionalen Strom $I_M$. Diese Mittel 14 enthalten einen Meßwiderstand 16 mit dem Widerstandswert $R_M$. Ein Eingang 18 eines Operationsverstärkers 20 liegt an der ersten Klemme 10 der Meßspannung U an. Der zweite Eingang des Operationsverstärkers 20 ist mit einem ersten Ende des Meßwiderstandes 16 verbunden. Mit diesem Eingang 22 und dem Ende des Meßwiderstandes 16 ist auch der Ausgang des Operationsverstärkers 20 verbunden. Der Operationsverstärker 20 liefert dann einen solchen Strom, der so über den Widerstand 16 fließt, daß das Potential am Ende des Meßwiderstandes 16 stets auf das potential der Eingangsklemme 10 angehoben wird.

Die zweite Eingangsklemme 12 der Meßspannung U ist mit einem Eingang 24 eines Operationsverstärkers 26 verbunden. Der andere Eingang 28 des Operationsverstärkers 26 ist mit dem zweiten Ende des Meßwiderstandes 16 verbunden. Der Ausgang des Operationsverstärkers 26 ist über einen elektronischen Schalter 30 auf der Basis eines Transistors 32 geschaltet. Der Transistor 32 ist über einen elektronischen Schalter 34 und eine Leitung 36 mit dem zweiten Ende des Widerstandes 16 verbunden. Der Transistor 32 wird so gesteuert, daß die Spannung zwischen den Eingängen 24 und 18 und damit die Potentialdifferenz zwischen dem zweiten (unteren) Ende des Meßwiderstands 16 und der zweiten Eingangsklemme 12 verschwindet. Durch den Meß-

3

widerstand 16 fließt dann ein eingeprägter, also von der Last unabhängiger Strom $I_M$, der der anliegenden Eingangsspannung U proportional ist und bei dem gleichsinnige Spannungserhöhungen auf den Leitungen 10 und 12 auf den Wandler ohne Einfluß sind. Dieser Strom $I_M$ fließt über Leitung 36, Schalter 34 und Transistor 32.

Mit 38 ist eine Referenzspannungsquelle bezeichnet. Die Referenzspannungsquelle 38 erzeugt gegen Masse eine Referenzspannung $U_{REF}$. Von der Referenzspannungsquelle 38 verläuft ein Stromkreis über einen Widerstand 40 mit einem Widerstandswert $R_1$, einen Schalter 42, den damit in Reihe liegenden Schalter 34 und Transistor 32. Der über diesen Stromkreis fließende Strom wird als Referenzstrom bezeichnet.

Ein zweiter Stromkreis verläuft von der Referenzspannungsquelle 38 über einen Widerstand 44 mit einem Widerstandswert $R_2$ einmal zu einem Eingang 46 eines Operationsverstärkers 48 und zum anderen über eine Diode 50 zu den zweiten "Kontakten" der als Umschalter ausgebildeten "Schalter" 34 und 42. Die Schalter sind natürlich elektronische Schalter, die nur der Anschaulichkeit halber als mechanische Kontakte dargestellt sind. Wenn hier von "Kontakten" gesprochen wird, dann sind die entsprechenden Anschlüsse der elektronischen Schalter gemeint.

Der zweite Eingang 52 des Operationsverstärkers 48 liegt an der Masse. Der Ausgang des Operationsverstärkers 48 ist mit dem zweiten "Kontakt" des ebenfalls als Umschalter ausgebildeten "Schalters" 30 verbunden. Über diesen Schalter 30 ist der Ausgang des Operationsverstärkers 48 mit der Basis des Transistors 32 in Punkt 62 verbindbar. Der Operationsverstärker 48 liefert einen eingeprägten Strom $I_E$, der als "oberer Abgleichstrom" bezeichnet wird.

Ein weiterer Operationsverstärker ist mit 54 bezeichnet. Ein erster Eingang 56 des Operationsverstärkers 54 liegt mit der Diode 50 und den zweiten Kontakten der Schalter 34 und 42 auf Null-Potential. Der zweite Operationsverstärker 54 liefert einen Strom, der als "unterer Abgleichstrom" bezeichnet wird. Der zweite Eingang des Operationsverstärkers 54 liegt wie der zweite Eingang des Operationsverstärkers 48 an Masse.

Durch einen Umschalter 55 ist in Abhängigkeit von einem Signal des Prozessors über eine Steuerleitung 57 entweder der Operationsverstärker 48 oder Operationsverstärker 54 einschaltbar. Ebenso sind durch ein Signal von dem Prozessor die Schalter 30, 34 und 42 in ihre jeweils andere Stellung umschaltbar. Das ist durch das die Schalter umschließende Kästchen 58 und eine Steuerleitung 60 dargestellt.

Über den Schalter 30 sind in dessen beiden Schaltstellungen entweder der Ausgang des Operationsverstärkers 26 oder die Ausgänge der Operationsverstärker 48 und 54 mit dem Punkt 62 verbindbar, der mit der Basis des Transistors 32 verbunden ist. Durch die Schalter 34 und 42 ist der Kollektor des Transistors 32 entweder gleichzeitig mit dem Widerstand 16 und Strom $I_M$ und dem Widerstand 40 und Strom $I_1$ verbunden oder gleichzeitig mit dem Widerstand 40 und dem Widerstand 44.

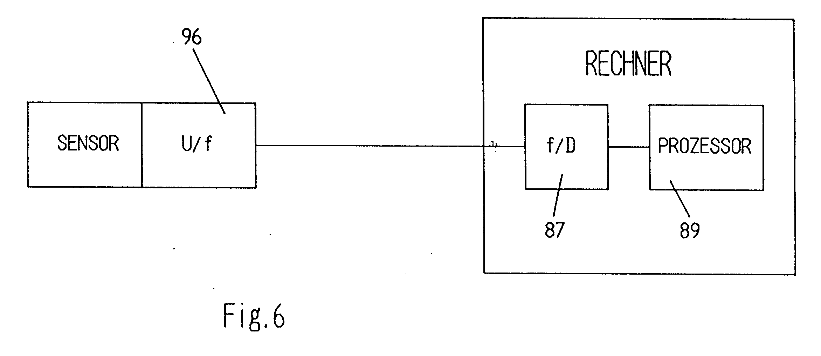

Parallel zu dem Transistor 32, an dessen Basis die Ausgangsspannung des Operationsverstärkers 26 oder eines der Operationsverstärker 48 oder 54 im Punkt 62 anliegt, werden die Transistoren 64 angesteuert. Die Transistoren 64 ziehen Strom von einem stromgesteuerten Oszillator 66. Der stromgesteuerte Oszillator 66 liegt an einer Referenzspannungsquelle 68, die durch den Kondensator 70 stabilisiert wird. Parallel zu zweien der Transistoren 64 liegt ein Kondensator 85. Mit diesem Kondensator 85 kann der stromgesteuerte Oszillator 66 von außen beschaltet werden, um den Frequenzbereich zu bestimmen. Der stromgesteuerte Oszillator 66 steuert über einen Verstärker 72 einen Ausgangstransistor 74. Der Ausgangstransistor liefert Impulsfolgen mit der Ausgangsfrequenz auf einer Ausgangsleitung 76. Die Ausgangsleitung 76 ist über einen Frequenz-Digital-Umsetzer 87 (Fig. 6) zu einem Prozessor 89 geführt.

Statt an einem Sensor entfernt von dem Prozessor kann der Analogsignal-Frequenz-Wandler auch innerhalb des Rechners angeordnet sein. Dabei wird dann nicht mehr der Vorteil der störungsarmen Übertragung genutzt, sondern die Tatsache, daß die Analogsignal-Frequenz-Wandlung unabhängig von der Umgebungstemperatur erfolgt.

Mit 78 ist eine Schaltung zur Drahtbruch-Erkennung bezeichnet. Die Schaltung 78 liefert ein Signal, das über einen Verstärker 80 und einen Ausgangstransistor 82 auf eine ebenfalls zu dem Prozessor laufende Ausgangsleitung 84 geführt wird.

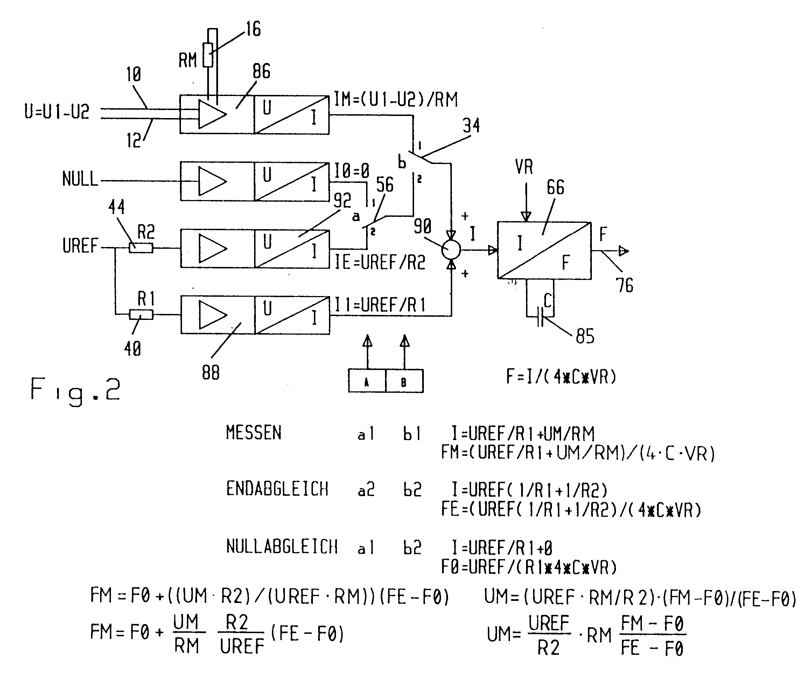

Die Wirkungsweise der beschriebenen Schaltung soll nachstehend unter Bezugnahme auf Fig. 2 näher erläutert werden, die in einem Blockschaltbild die Addition der verschiedenen eingeprägten Ströme zeigt.

Die Potentiale $U_1$ und $U_2$ liegen an den Eingangsklemmen 10 und 12. Die Differenz dieser Potentiale, die Meßspannung

$$U = U_1 - U_2$$

wird an dem Meßwiderstand 16 mit dem Widerstandswert $R_M$ abgebildet, mit welchem die Schaltung, wie beschrieben, von außen beschaltet ist. Die Meßspannung U wird in einen zu U proportionalen, eingeprägten Strom umgesetzt. Das geschieht durch einen U/I-Wandler, der in Fig. 2 mit 86 bezeichnet ist. Der U/I-Wandler 86 liefert einen Meßstrom

$$I_M = (U_1 - U_2)/R_M.$$

Ein Referenzstrom $I_1$ wird durch die Referenzspannung $U_{REF}$ des Referenzgenerators 34 erzeugt, die an dem Widerstand 40 mit dem Widerstandswert $R_1$ anliegt. Ein U/I-Wandler 88 sorgt dafür, daß dieser Strom ein eingeprägter, also lastunabhängiger Strom ist. Dieser Referenzstrom

$$I_1 = U_{REF}/R_1$$

wird auf einem Summierpunkt 90 geschaltet. Der Meßstrom $I_M$ wird in Fig. 2 auch auf den Summierpunkt 90 über einen Schalter 34 aufgeschaltet. Der Referenzstrom $I_1$ ist über den Schalter 42 stets aufgeschaltet. Daher ist der Schalter 42 in Fig. 2 nicht dargestellt. In der dargestellten Stellung der Schalter 34 und 42 in Fig. 1 bzw. des Schalters 34 in Fig. 2 wird an dem Summierpunkt 90 ein Strom

$$I = I_1 + I_M$$

erzeugt. Dieser Strom wird auf dem stromgesteuerten Oszillator 66 gegeben. Der Oszillator 66 liefert eine dem Meßsignal zugeordnete Ausgangsfrequenz

$$F_M = (U_{REF}/R_1 + U/R_M)/ (4 C U_R),$$

wobei C die Kapazität des Kondensators 85 und $U_R$ die Referenzspannung von der Referenzspannungsquelle 68 ist. Die Frequenz $F_M$ wird einem Frequenz-Digital-Umsetzer 87 (Fig. 6) zugeführt, von dem der Prozessor den digitalen Wert von $F_M$ erhält. Der Prozessor erzeugt dann ein Signal auf der Steuerleitung 60. Dadurch werden die Schalter 30, 34 und 42 der Schaltanordnung 58 umgeschaltet.

In Fig. 2 liegt die Referenzspannung $U_{REF}$ auch an einem Widerstand 44 (entsprechend dem Widerstand 44 von Fig. 1). Es ergibt sich ein Strom $I_E = U_{REF}/R_2$. Ein U/I-Wandler 92 sorgt dafür, daß dieser Strom ein lastunabhängiger eingeprägter oberer Abgleichstrom ist. Nach der Umschaltung des Schalters 34 in Fig. 2 ergibt sich an dem Summierpunkt 90 ein Summenstrom

$$I = I_1 + I_E.$$

Dieser Summenstrom steuert den stromgesteuerten Oszillator 66. Der Oszillator liefert dementsprechend eine dem oberen Ende des Meßbereiches entsprechende Ausgangsfrequenz

$$F_E = U_{REF}(1/R_1 + 1/R_2) / ( 4 C U_R).$$

Anschließend erfolgt die Frequenzumwandlung am Bereichsnullpunkt. Dazu wird gesteuert von dem Prozessor der Schalter 56 durch ein Signal an der Steuerleitung 57 umgeschaltet. Hierdurch wird der Operationsverstärker 48 abgeschaltet und der Operationsverstärker 54 eingeschaltet. Es werden jetzt im Summierpunkt 90 die Ströme $I_1$ und $I_0$ überlagert, wobei $I_0 = 0$ ist, wenn dem Bereichsnullpunkt das Eingangssignal null zugeordnet ist. Der Summenstrom

$$I = I_1 + I_0$$

wird auf den stromgesteuerten Oszillator 66 gegeben. Der Oszillator 66 liefert eine Ausgangsfrequenz für den Bereichsnullpunkt von

$$F_0 = U_{REF}/(R_1 . 4CU_R)$$

Auch diese Ausgangsfrequenz wird über die Leitung 76 über den Frequenz-Digital-Umsetzer 87 auf den Prozessor übertragen.

Der Prozessor ist nun so eingerichtet, daß er aus den erhaltenen und gespeicherten drei Digitalwerten der drei Frequenzen die Meßspannung $U_M$ bildet nach der Beziehung:

$$U_M = (U_{REF} * R_M/R_2) * (F_M - F_0)/(F_E - F_0)$$

Dabei ist $U_M$ der Digitalwert, welcher der analogen Eingangsspannung U zugeordnet ist. Man erkennt, daß in diesem Ausdruck die erste Klammer eine Konstante darstellt, für welche die Nominalwerte von $U_{REF}$ und den Widerstandswerten der Widerstände 16 und 44 eingesetzt werden, während der weitere Ausdruck variabel ist und von den gemessenen Frequenzen abhängt.

Die Schaltung, die in der Umrahmung in Fig. 1 angeordnet ist, ist als integrierter Schaltungsbaustein ausgebildet.

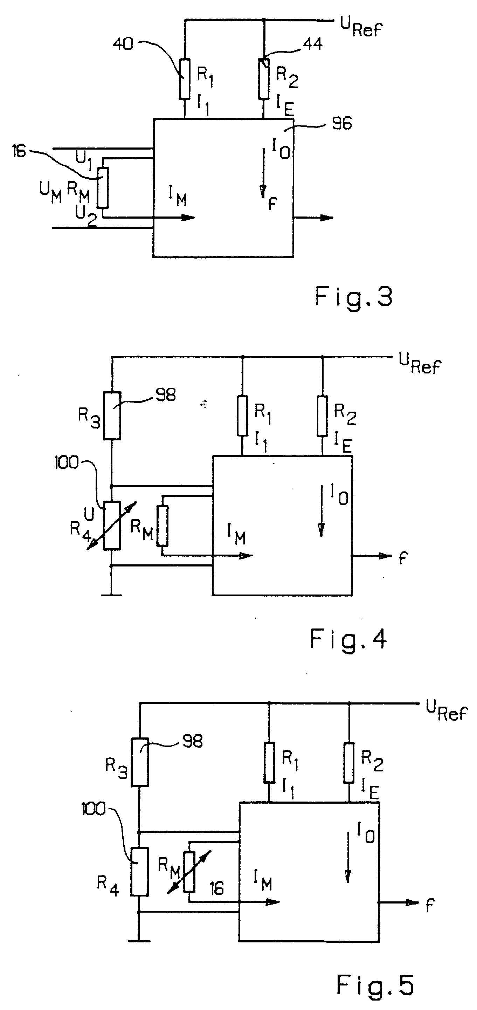

In Fig. 3 und Fig. 6 ist dieser integrierte Schaltungsbaustein mit 96 bezeichnet. Der Schaltungsbaustein 96 ist von außen mit einem geeigneten Meßwiderstand 16 und den Widerständen 40 und 44 beschaltet, durch die die Meßbereiche festgelegt werden. Auch die Referenzspannung wird von außen angelegt und kann geeignet gewählt werden.

Fig. 4 zeigt eine Beschaltung des integrierten Schaltungsbausteins 96 so, daß ein variabler elektrischer Widerstand die Meßgröße bildet. Zu diesem Zweck ist ein Spannungsteiler mit einem festen Widerstand 98 und dem zu digitalisierenden variablen Widerstand 100 gebildet. Dieser Spannungsteiler liegt an der Referenzspannung. An dem variablen Widerstand fällt dann eine Spannung ab, die als Meßspannung in der beschriebenen Weise behandelt werden kann. Bezeichnet man mit $R_3$ den Widerstandswert des Widerstandes 98 und mit $R_4$ den Widerstandswert des Widerstandes 100, dann ergibt sich

$$R_4 = R_M * R_3 * (F_M - F_0) / (R_2 * (F_E - F_0) - R_M * (F_M - F_0)).$$

Eine andere Möglichkeit zeigt Fig. 4. Dort bilden die Widerstände des Spannungsteilers feste Widerstände. Als zu messender und zu digitalisierender Widerstandswert dient der Widerstandswert des "Meßwiderstandes" 16. Hierbei ergibt sich:

$$R_M = (R_2 * R_4/(R_3 + R_4)) * ((F_E - F_0) / (F_M - F_0)).$$
Die Widerstandsmessungen sind unabhängig von der Referenzspannung $U_{REF}$.

## Patentansprüche

1. Schaltungsanordnung zur Analogsignal-Frequenz-Wandlung zur Verwendung mit einem Frequenz-Digital-Umsetzer und einem Prozessor, enthaltend:

   (a) einen Eingang (10,12), an welchem ein analoges Eingangssignal anliegt,

   (b) Mittel (38,44,48,50,54) zur Erzeugung von bekannten, analogen Abgleichsignalen und

   (c) Wandlermittel (66) durch welche das analoge Eingangssignal und die Abgleichsignale in vorgegebener Folge in je eine Frequenz umsetzbar sind,

   (d) wobei durch den Prozessor (89) ein Digitalwert des analogen Eingangssignals aus den beiden Digitalwerten, die aus den durch die Abgleichsignale erzeugten Frequenzen erhalten werden, und aus dem Digitalwert der durch das analoge Eingangssignal erzeugten Frequenz berechenbar ist,

   **gekennzeichnet durch**

   (e) Mittel zum Umsetzen des analogen Eingangssignals und der Abgleichsignale in eingeprägte Ströme, enthaltend

   - einen gemeinsamen Transistor (32),
   - jeweils einen ohmschen Widerstand (16;44), der von dem Eingangs- bzw. Abgleichsignal beaufschlagt ist und der mit der Emitter-Kollektor-Strecke des gemeinsamen Transistors (32) in Reihe schaltbar ist,
   - jeweils einen Operationsverstärker (26;48,54), an dessen Eingangsklemmen ein durch den Spannungsabfall an dem zugehörigen ohmschen Widerstand (16;44) bestimmtes Potential gegen ein Referenzpotential geschaltet ist und dessen Ausgang auf die Basis des gemeinsamen Transistors (32) geschaltet ist, sodaß der durch den ohmschen Widerstand und den Transistor fließende Strom ein eingeprägter Strom proportional dem Eingangs- bzw. Abgleichsignal ist,

   (f) elektronische Schaltmittel (55,58) zum Aufschalten der Widerstände und der zugehörigen Operationsverstärker in vorgegebener Folge auf den Transistor (32), und

   (g) einen stromgesteuerten Oszillator (66), auf den die eingeprägten Ströme von dem Transistor aufgeschaltet sind und der als die besagten Wandlermittel die Ausgangsfrequenz liefert.

2. Schaltungsanordnung nach Anspruch 1, **dadurch gekennzeichnet, daß** die elektronischen Bauelemente der Mittel zur Umsetzung des Eingangssignals und der Abgleichsignale in eingeprägte Ströme und die Wandlermittel zu einem integrierten Schaltungsbauteil vereinigt sind.

3. Schaltungsanordnung nach Anspruch 1 oder 2, dadurch **gekennzeichnet, daß** die Mittel zur Umsetzung des Eingangssignals in einen eingeprägten Strom enthalten:

   (a) einen Meßwiderstand (16), dessen eines Ende durch einen ersten Operationsverstärker (20) auf dem Potential einer Eingangsklemme (10) des Eingangs für das Eingangssignal (U) gehalten ist,

   (b) einen zweiten Operationsverstärker (26), dessen eine Eingangsklemme (28) mit dem anderen Ende des Meßwiderstandes (16) und dessen andere Eingangsklemme (24) mit der zweiten Eingangsklemme (12) des Eingangs für das Eingangssignal (U) verbindbar ist, und

   (c) den Transistor (32), dessen Kollektor über die elektronischen Schaltmittel (58) mit dem besagten anderen Ende des Meßwiderstandes und dessen Basis über die elektronischen Schaltmittel (58) mit dem Ausgang des zweiten Operationsverstärkers (26) verbunden ist.

4. Schaltungsanordnung nach Anspruch 3, **dadurch gekennzeichnet, daß**

   (a) die erste Eingangsklemme (10) des Einganges für das Eingangssignal (U) mit einer Eingangsklemme (18) des ersten Operationsverstärkers (20) verbunden ist und

   (b) die zweite Eingangsklemme (22) des zweiten Operationsverstärkers (26) und der Ausgang dieses Operationsverstärkers (26) mit dem besagten einen Ende des Meßwiderstandes (16) verbunden ist.

5. Schaltungsanordnung nach Anspruch 3 oder 4, **dadurch gekennzeichnet, daß**

   (a) die Mittel zur Umsetzung der Abgleichsignale in eingeprägte Ströme einen dritten und einen vierten Operationsverstärker (48 bzw. 54) enthalten, die gesteuert von dem Prozessor nacheinander einschaltbar sind,

   (b) jeweils eine Eingangsklemme jedes dieser Operationsverstärker (48 bzw. 54) an Masse liegt,

(c) die andere Eingangsklemme des dritten Operationsverstärkers (48) über einen festen Widerstand (44) mit einer Referenzspannung und über eine Diode (50) und die elektronischen Schaltmittel (58) mit dem Kollektor des Transistors (32) verbunden ist,

(d) die andere Eingangsklemme (56) des vierten Operationsverstärkers (54) über den besagten festen Widerstand (44) und die Diode (50) mit der Referenzspannung und ebenfalls mit dem Kollektor des Transistors (32) verbunden ist,

(e) die Ausgänge des dritten und des vierten Operationsverstärkers (48 bzw. 54) über die elektronischen Schaltmittel (58) mit der Basis des Transistors (32) verbunden sind.

6. Schaltungsanordnung nach Anspruch 5, **dadurch gekennzeichnet, daß** der Kollektor des Transistors (32) über einen festen Widerstand (40) mit der Referenzspannung verbunden ist.

7. Schaltungsanordnung nach einem der Ansprüche 1 bis 6, **dadurch gekennzeichnet, daß**

(a) der stromgesteuerte Oszillator (66) durch einen Strom gesteuert ist, der von Transistoren (64) gezogen wird, und

(b) die Basen der stromziehenden Transistoren (64) mit der Basis des Transistors (32) und die Emitter der stromziehenden Transistoren (64) mit dem Emitter des Transistors (32) verbunden sind.

## Claims

1. Circuit arrangement for analog signal-to-frequency conversion for use with a frequeny-digital converter and a processor, containing:

(a) an input (10,12) to which an analog input signal is applied,

(b) means (38,44,48,50,54) for producing known analog balancing signals,

(c) converter means (66) by means of which each one of the analog input signal and the balancing signals are convertable in predetermined sequence into a respective frequency,

(d) whereby a digital value of the analog input signal is computable by means of the processor (89) from the two digital values, which are obtained from the frequencies produced by the balancing signals, and from the digital value of the frequency, which is produced by the analog input signal,

**characterized in that**

(e) means for converting the analog input signal and the balancing signals into load independent currents, including:

- a common transistor (32),
- ohmic resistors (16;44) to which the input signal and the balancing signal are respectively applied and which are series-connectable to the emitter-collector path of the common transistor (32),
- respective operational amplifiers (26;48,54) having input terminals at which a potential, which is determined by the voltage drop at the associated resistor (16;44), is connected in opposition to a reference potential, and having outputs connected to the base of the common transistor (32) such that the current flowing through the ohmic resistor and the transistor constitutes a load independent current which is proportional to the input signal and the balancing signal, respectively,

(f) electronic switching means (55,58) for connecting the resistors and the associated operational amplifiers to the transistor (32) in predetermined sequence, and

(g) a current-controlled oscillator (66) to which the load independent currents are applied and which acts as the said converter means to provide the output frequency.

2. Circuit arrangement according to claim 1, **characterized in that** the electronic components of the means for converting the input signal and the balancing signals into load independent currents as well as the converter means are combined to an integrated circuit component.

3. Circuit arrangement according to claim 1 or 2, **characterized in that** the means for converting the input signal into a load independent current include:

(a) a measuring resistor (16) having one end which is held at the potential of an input terminal (10) of the input, which receives the input signal (U), by means of a first operational amplifier (20),

(b) a second operational amplifier (26) having one input terminal (28), which is connectable to the other end of the measuring resistor (16), and a further input terminal (24) which is connectable to the second inpt terminal (12) of the input receiving the input signal (U),

(c) the transistor (32), the collector of which is connected through the electronic switching means (58)

7

to the said other end of the measuring resistor, the base of the transistor being connected through the electronic switching means (58) to the output of the second operational amplifier (26).

4. Circuit arrangement according to claim 3, **characterized in that**
(a) the first input terminal (10) of the input receiving the input signal (U), is connected to one input terminal (18) of the first operational amplifier (20) and
(b) the second input terminal (22) of the second operational amplifier (26) and the output of this operational amplifier (26) are connected to the said one end of the measuring resistor (16).

5. Circuit arrangement according to claim 3 or 4, **characterized in that**
(a) the means for converting the balancing signals into load independent currents include a third and a fourth operational amplifier (28 and 54, respectively) which are successively activatable under control of the processor,
(b) one of the input terminals of each one of these operational amplifiers (48 and 54, respectively) is connected to ground,
(c) the other input terminal of the third operational amplifier (48) is connected via a fixed resistor (44) to a reference voltage and via a diode (50) and the electronic switching means (58) to the collector of the transistor (32),
(d) the other input terminal (56) of the fourth operational amplifier (54) is connected to the reference voltage via the said fixed resistor (44) and the diode (50) and also to the collector of the transistor (32),
(e) the outputs of the third and fourth operational amplifiers (48 and 54, respectively) are connected to the base of the transistor (32) via the electronic switching means (58).

6. Circuit arrangement according to claim 5, **characterized in that** the collector of the transistor (32) is connected to the reference voltage through a fixed resistor (40).

7. Circuit arrangement according to any one of claims 1 to 6, **characterized in that**
(a) the current-controlled oscillator (66) is controlled by means of a current which is drawn from transistors (64), and
(b) the bases of the current-drawing transistors (64) are connected to the base of the transistor (32) and the emitters of the current-drawing transistors are connected to the emitter of the transistor (32).

**Revendications**

1. Arrangement de circuit destiné à la transformation signal analogique-fréquence destiné à être utilisé avec un convertisseur fréquence-numérique et un processeur, contenant:
(a) une entrée (10, 12) à laquelle est appliqué un signal analogique d'entrée,
(b) des moyens (38, 44, 48, 50, 54) destinés à produire des signaux d'égalisation analogiques connus et
(c) des moyens transformateurs (66) par lesquels le signal analogique d'entrée et les signaux d'égalisation sont susceptibles d'être convertis dans un ordre déterminé en chaque fois une fréquence,
(d) une valeur numérique du signal analogique d'entrée étant susceptible d'être calculée par le processeur (89) à partir des deux valeurs numériques obtenues à partir des fréquences produites par les signaux d'égalisation, et à partir de la valeur numérique de la fréquence produite par le signal analogique d'entrée,
**caractérisé par**
(e) des moyens destinés à convertir le signal analogique d'entrée et les signaux d'égalisation en courants indépendants de la charge, comprenant
- un transistor (32) commun.
- chaque fois une résistance ohmique (16;44) à laquelle sont appliqués le signal d'entrée et le signal d'égalisation respectivement et qui est susceptible d'être appliquée à la suite avec le segment émetteur-collecteur du transistor (32) commun,
- chaque fois un amplificateur opérationnel (26; 48, 54) aux bornes d'entrée duquel un potentiel déterminé par la chute de courant à la résistance (16;44) ohmique y appartenant est appliqué en proportion d'un potentiel de référence et dont la sortie est appliquée à l'électrode de base du transistor (32) commun si bien que le courant circulant par la résistance ohmique et le transitor est un courant indépendant de la charge et proportionnel au signal d'entrée et au signal d'égalisation respectivement,

(f) des moyens électroniques de commutation (55, 58) destinés à appliquer les résistances et les amplificateurs opérationnels y appartenant dans un ordre déterminé au transistor (32), et

(g) un oscillateur (66) commandé par courant auquel les courants du transistor indépendants de la charge sont appliqués et qui fournit les fréquences de sortie en tant que moyens transformateurs mentionnés.

2. Arrangement de circuit selon la revendication 1, **caractérisé par le fait que** les éléments électroniques des moyens destinés à convertir le signal d'entrée et les signaux d'égalisation en courants indépendants de la charge ainsi que les moyens transformateurs sont réunis en un élément de circuit intégré.

3. Arrangement de circuit selon la revendication 1 ou 2, **caractérisé par le fait que** les moyens destinés à convertir le signal d'entrée en un courant indépendant de la charge contiennent:

(a) une résistance de mesure (16) dont l'une des extrémités est considérée par un premier amplificateur opérationnel (20) sur le potentiel d'une borne d'entrée (10) de l'entrée pour le signal d'entrée (U),

(b) un deuxième amplificateur opérationnel (26) dont une des bornes d'entrée (28) est susceptible d'être reliée à l'autre extrémité de la résistance de mesure (16) et dont l'autre borne d'entrée (24) est susceptible d'être reliée à la deuxième borne d'entrée (12) de l'entrée pour le signal d'entrée (U), et

(c) le transistor (32) dont le collecteur est reliée par l'intermédiaire des moyens électroniques de commutation (58) à l'autre extrémité mentionnée de la résistance de mesure et dont l'électrode de base est reliée par l'intermédiaire des moyens électroniques de commutation (58) à la sortie du deuxième amplificateur opérationnel (26).

4. Arrangement de circuit selon la revendication 3, **caractérisé par le fait que**

(a) la première borne d'entrée (10) de l'entrée pour le signal d'entrée (U) est reliée à une borne d'entrée (18) du premier amplificateur opérationnel (20) et

(b) la deuxième borne d'entrée (22) du deuxième amplificateur opérationnel (26) et la sortie de cet amplificateur opérationnel (20) sont reliées à l'une des extrémités mentionnées de la résistance de mesure (16).

5. Arrangement de circuit selon la revendication 3 ou 4, **caractérisé par la fait que**

(a) les moyens destinés à convertir les signaux d'égalisation en courants indépendants de la charge contiennent un troisième et un quatrième amplificateur opérationnel (48 et 54) qui, commandés par le processeur, sont susceptibles d'être appliqués l'un après l'autre,

(b) chaque fois une borne d'entrée de chacun de ces amplificateurs opérationnels (48 et 54) est appliquée à la masse,

(c) l'autre borne d'entrée du troisième amplificateur opérationnel (48) est reliée par l'intermédiaire d'une résistance fixe (44) à un tension de référence et par l'intermédiaire d'une diode (50) et des moyens électroniques de commutation (58) au collecteur du transistor (32),

(d) l'autre borne d'entrée (56) du quatrième amplificateur opérationnel (54) est reliée par l'intermédiaire de la résistance fixe (44) mentionnée et de la diode (50) à la tension de référence et également au collecteur du transistor (32),

(e) les sorties du troisième et quatrième amplificateur opérationnel (48 et 54) sont reliées par l'intermédiaire des moyens électroniques de commutation (58) à l'électrode de base du transistor (32).

6. Arrangement de circuit selon la revendication 5, **caractérisé par le fait que** le collecteur du transistor (32) est relié par l'intermédiaire d'une résistance fixe (40) à la tension de référence.

7. Arrangement selon l'une des revendications 1 à 6, **caractérisé par le fait que**

(a) l'oscillateur (66) commandé par courant est commandé par un courant alimenté par des transistors (64) et

(b) les électrodes de base des transistors (64) alimentés par courant sont reliées à l'électrode de base du transistor (32) et les émetteurs des transistors (64) alimentés par courant à l'émetteur du transistor (32).

Fig.1

VON μP

ENABLE A

ENABLE B

+VCC

STROM-
GESTEU-
ERTER
OSZILLA-
TOR

MASSE

NULL

DRAHTBRUCH
ERKENNUNG

$I_E$ ODER $I_0$

$I_M$

-VSS

EP 0 412 573 B1

EP 0 412 573 B1

Fig. 2

$$IM = (U1-U2)/RM$$
$$U = U1 - U2$$
$$I0 = 0$$
$$IE = UREF/R2$$
$$I1 = UREF/R1$$
$$F = I/(4 \ast C \ast VR)$$

| | | | |
|---|---|---|---|
| MESSEN | a1 | b1 | $I = UREF/R1 + UM/RM$ |
| | | | $FM = (UREF/R1 + UM/RM)/(4 \cdot C \cdot VR)$ |
| ENDABGLEICH | a2 | b2 | $I = UREF(1/R1 + 1/R2)$ |
| | | | $FE = (UREF(1/R1 + 1/R2))/(4 \ast C \ast VR)$ |
| NULLABGLEICH | a1 | b2 | $I = UREF/R1 + 0$ |
| | | | $F0 = UREF/(R1 \ast 4 \ast C \ast VR)$ |

$$FM = F0 + ((UM \cdot R2)/(UREF \cdot RM))(FE - F0)$$

$$UM = (UREF \cdot RM/R2) \cdot (FM - F0)/(FE - F0)$$

$$FM = F0 + \frac{UM}{RM} \frac{R2}{UREF}(FE - F0)$$

$$UM = \frac{UREF}{R2} \cdot RM \frac{FM - F0}{FE - F0}$$

Fig.3

Fig.4

Fig.5

12

96

| SENSOR | U/f |
|--------|-----|

RECHNER

f/D

PROZESSOR

87

89

Fig.6